# EUROPEAN PATENT SPECIFICATION

(11) **EP 4 465 535 B1**
(45) Date of publication and mention of the grant of the patent: **17.12.2025**
(21) Application number: 23305778.5
(22) Date of filing: 16.05.2023
(51) Int. Cl.: H03F 1/22, H03F 3/19, H03F 1/30, H03F 3/21, H03F 3/50

(54) **BIAS CIRCUIT**
VORSPANNUNGSSCHALTUNG
CIRCUIT DE POLARISATION

(43) Date of publication of application: 20.11.2024
(73) Proprietor: NXP B.V., 5656 AG Eindhoven (NL)
(72) Inventor: Yang, Xin, 31023 Toulouse (FR); David, Stephane, 31023 Toulouse (FR); van der Heijden, Mark Pieter, 31023 Toulouse (FR); Leenaerts, Dominicus MARTINUS WILHELMUS, 31023 Toulouse (FR)
(74) Representative: Miles, John Richard

(56) References cited:
- US-A1- 2005 179 484
- US-A1- 2008 238 553
- US-A1- 2018 062 579
- US-A1- 2021 126 600
- US-A1- 2023 006 623

## Description

### FIELD

This disclosure relates to a bias circuit for a radio frequency (RF) amplifier.

### BACKGROUND

RF power amplifiers typically have a common-emitter stage and optionally a common-base stage each having an associated bias circuit to adaptively control the bias condition over the output power to enhance the linearity. A popular way of designing a common-emitter (CE) adaptive bias circuit uses the rectification effect to increase the Vbe bias voltage of the CE stage with increasing output power. However in such bias circuits, the bias current of RF amplifier is very sensitive to process spread, in particular for NPN bipolar transistors the process spread of the NPN beta parameter. US 2021/126600 Al describes a power amplifier module and power amplification method. US 2018/062579 Al describes a power amplification circuit. US 2005/179484 Al describes a bias voltage supply circuit and radio-frequency amplification circuit. US 2023/006623 Al describes a bias circuit of power amplifier, device and equipment. US 2008/238553 Al describes a power amplifying device having linearizer.

### SUMMARY

Aspects of the disclosure are defined in the accompanying claims. In a first aspect, there is provided bias circuit for a RF amplifier according to claim 1.

### BRIEF DESCRIPTION OF THE DRAWINGS

In the figures and description like reference numerals refer to like features. Embodiments are now described in detail, by way of example only, illustrated by the accompanying drawings in which:
Figure 1 shows a RF amplifier system including a bias circuit.
Figure 2 illustrates an alternative RF amplifier circuit.
Figure 3A shows a RF amplifier system including a bias circuit.
Figure 3B shows a bias circuit.
Figure 4 illustrates a RF amplifier system including a bias circuit.
Figure 5A illustrates a RF amplifier system including a bias circuit according to an embodiment.
Figure 5B illustrates a bias circuit according to an embodiment.
Figure 6 shows graphs showing amplifier linearity for a continuous wave ( CW) signal showing the effect of varying a capacitor in the RF amplifier of figure 5.
Figure 7 shows graphs showing amplifier OIP3 vs. tone spacing with and without one of the capacitors in the RF amplifier of figure 5A.
Figures 8A, 8B, 8C illustrate graph of amplifier linearity with different current bias trimming schemes.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DETAILED DESCRIPTION OF EMBODIMENTS

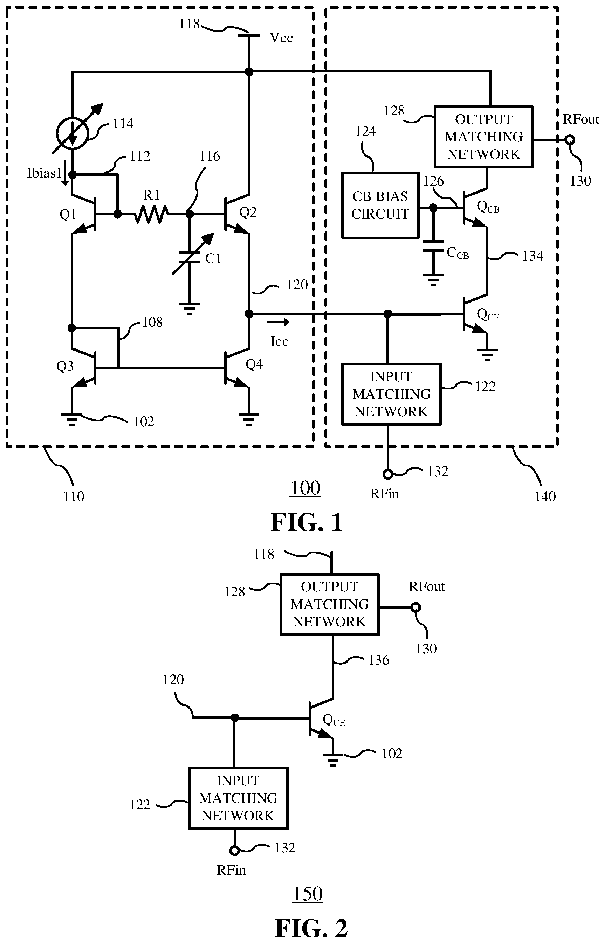

Figure 1 shows an RF amplifier 100 including a bias circuit 110 for a common emitter stage in an RF amplifier circuit according to an embodiment. The bias circuit 110 includes a first current mirror including first NPN bipolar transistor Q1 and second NPN bipolar transistor Q2 and a second current mirror including a third NPN bipolar transistor Q3 and a fourth NPN bipolar transistor Q4. The emitters of third and fourth NPN bipolar transistors Q3 and Q4 are connected to ground 102. The bias circuit output 120 is connected to the collector of the fourth bipolar NPN transistor Q4 and to the emitter of the second NPN bipolar transistor Q2. The circuit node 108 is connected to the emitter of the first NPN bipolar transistor Q1, collector of the third NPN bipolar transistor Q3, the base of the third NPN bipolar transistor Q3 and the base of the fourth NPN bipolar transistor Q4. The circuit node 112 is connected to the base of the first NPN bipolar transistor Q1, the collector of the first NPN bipolar transistor Q1, a first terminal of variable current source 114 , and a first terminal of a first resistor R1. The first NPN bipolar transistor Q1 and the third NPN bipolar transistor Q3 may be referred to as diode connected transistors. Circuit node 116 may be connected to a second terminal of the first resistor R1, a first terminal of a variable capacitor C1 and the base of the second NPN bipolar transistor Q2. A second terminal of the variable capacitor C1 may be connected to ground 102. A voltage supply node 118 is connected to a second terminal of variable current source 114 and a collector of the second NPN bipolar transistor Q2. The term variable capacitor as used herein refers to a capacitor or other element or collection of elements where the capacitance may be varied such as but not limited to a varactor or switchable capacitor network. The term voltage supply node refers to a node which is configured to be connected to a voltage supplying power to the circuit when in operation.

The bias circuit 110 may be connected to RF amplifier circuit 140 which as illustrated includes a common base transistor Q_{CB} and a common emitter transistor Q_{CE} in a cascode configuration. The bias circuit output 120 is connected to the base of the common emitter transistor Q_{CE}. An input matching network 122 is connected between an RF amplifier input 132 and the base of the common emitter transistor Q_{CE}. The common base transistor Q_{CB} base is connected to a common base bias circuit output 126 from common base bias circuit 124. A capacitor C_{CB} is connected between the common base bias circuit output 126 and a ground 102. An output matching network 128 has a first terminal connected to supply node 118, a second terminal connected to a collector of the common base transistor Q_{CB} and a third terminal connected to an RF amplifier output 130. Circuit node 134 is connected to the emitter of the common base transistor Q_{CB} and the collector of the common emitter transistor Q_{CE}.

The bias circuit 110 may provide a bias current determined by the variable current source 114 which is copied by the first current mirror and provided to the bias circuit output 120. The fourth NPN bipolar transistor Q4 acts as a tail current source and so the emitter current of the second NPN bipolar transistor Q2 is not dominated by the base current of the common emitter transistor. This may improve the robustness of the Icc bias current of the common emitter transistor Q_{CE} with respect to variations in process spread. The variable capacitor C1 adds extra trimming capability of amplifier linearity for a continuous wave (CW) signal. The variable capacitor C1 may control the amplitude modulation (AM) to AM (AMAM) characteristic (i.e. the instantaneous gain versus signal power characteristic ) without impacting the AM to phase modulation (PM) (AMPM) characteristic (i.e. the instantaneous phase versus signal power characteristic ) and quiescent bias current of amplifier.

In operation when the RF input power of an RF signal applied to RF input 132 increases, the RF voltage swing at base-to-emitter junction of the second NPN bipolar transistor Q2 is correspondingly increased. Since the dc component of the emitter current (IE_dc) of transistor Q2 is fixed, the Q2 base-to-emitter junction is rectified and Vbe_dc of Q2 is decreased. Consequently the base-emitter DC voltage (Vbe_dc) of Q2 is adaptively increased with increasing input and output power.

The resistance value of R1 is chosen to be relatively large, for example 800 Ohms to 5 KOhm and blocks the RF signal. The variable capacitor C1 may provide capacitive feedback for transistor Q2. The value of capacitance depends on the frequency of operation. In a non-limiting example, for a 100 GHz operating frequency, the capacitance value may be in the range of 5fF to 20fF. Other values may be used for other operating frequencies. If the capacitance of variable capacitor C1 increases, the RF signal swing across the base-to-emitter junction of transistor Q2 will increase, and transistor Q2 is more strongly rectified. This results in a greater decrease of Vbe_dc of Q2. Hence, the Q2 Vbe_dc increase with increasing output power (Pout) is higher with a larger value of variable capacitor C1. In some examples for example for a 100 GHz power amplifier, the capacitor value may be varied between 2 and 20 fF. The variable capacitor C1 may be implemented by way of example but not limited to a varactor or a switchable capacitor network. The variable current source 114 may be implemented as a switchable current mirror or IDAC (Digital-to-Analog Convertor with current output). In other examples, the variable current source may be replace with a fixed current source.

In some examples, the RF amplifier circuit 140 may be replaced by another amplifier circuit, for example common-emitter RF amplifier circuit 150 shown in Figure 2 which does not have the common-base transistor Q_{CB} and the common-base bias circuit 124. In amplifier circuit 140, the circuit node 136 connects the second terminal of the output matching network 128 and the collector of the common-emitter transistor Q_{CE}.

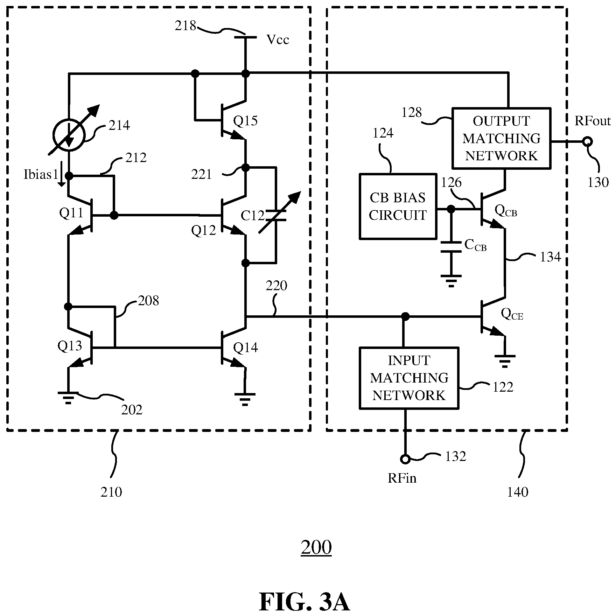

Figure 3A shows an RF amplifier 200 including a bias circuit 210 according to an embodiment. The bias circuit 210 includes a first current mirror including first NPN bipolar transistor Q11 and second NPN bipolar transistor Q12 and a second current mirror including a third NPN bipolar transistor Q13 and a fourth NPN bipolar transistor Q14. The emitters of third and fourth NPN bipolar transistors Q13 and Q14 are connected to ground 202. The bias circuit output 220 is connected to the collector of the fourth bipolar NPN transistor Q14 and to the emitter of the second NPN bipolar transistor Q12. The circuit node 208 is connected to the emitter of the first NPN bipolar transistor Q11, collector of the third NPN bipolar transistor Q13, the base of the third NPN bipolar transistor Q13 and the base of the fourth NPN bipolar transistor Q14. The circuit node 212 is connected to the base of the first NPN bipolar transistor Q11, the collector of the first NPN bipolar transistor Q11, a first terminal of variable current source 214 , the base of the second NPN bipolar transistor Q12. The first NPN bipolar transistor Q11 and the third NPN bipolar transistor Q13 may be referred to as diode connected transistors.

Node 221 is connected to a first terminal of a variable capacitor C12, the emitter of a fifth NPN bipolar transistor Q15 and the collector of the second NPN bipolar transistor Q12. A second terminal of the variable capacitor C12 is connected to the bias circuit output 220.

A voltage supply node 218 is connected to a second terminal of variable current source 214, the collector and base of the fifth NPN bipolar transistor Q15. As illustrated the bias circuit 210 is connected to RF amplifier circuit 140. In other examples different RF amplifier circuits for example RF amplifier circuit 150 may be used.

In operation, the first and second current mirrors operate in a similar way as described for bias circuit 110. The variable capacitor C12 and fifth NPN bipolar transistor Q15 may improve the modulation bandwidth of RF amplifier 200 by reducing the memory effect due to the dependence of the output on the RF output 130 on the previous input on RF input 132 which degrades the linearity of the RF amplifier 200. The fifth NPN bipolar transistor Q15 in diode connection is required otherwise the variable capacitor C12 is directly connected to the voltage supply 218 which is a RF ground and consequently the modulation bandwidth would not be improved.

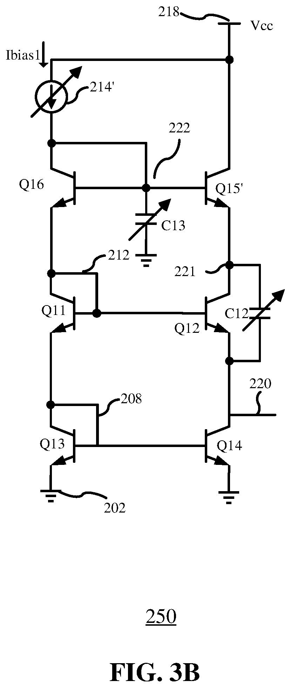

Figure 3B shows a bias circuit 250 for an RF amplifier which is similar to bias circuit 210. In the bias circuit 250, the fifth transistor Q15' has a base connected to circuit node 222, a collector connected to the supply node 218 and an emitter connected to circuit node 221. The first current bias 214' is connected between the supply node 218 and circuit node 222. A sixth bipolar NPN transistor Q16 has a base and collector connected to circuit node 222. A capacitor C13 which may be a variable capacitor may have a first terminal connected to circuit node 222 and a second terminal connected to ground 202. In other respects the circuit is the same as bias circuit 210.

In bias circuit 210, the base of the fifth transistor Q15 is directly connected to the first supply node 218. Consequently, when there is variation of the supply voltage Vcc, since the Vbe of Q15 is determined by emitter current and is independent of Vcc, the emitter voltage of Q15 (also the collector voltage of Q12) at node 221 is changing due to the Vcc variation. If Vcc increases, collector voltage of Q12 increases. Due to the Early effect of the NPN transistor, Vbe of Q12 decreases and causes the base voltage of QCE at node 220 increases. Hence, the bias current of RF amplifier 140 is changing as Vcc varies.

The addition of the sixth bipolar transistor Q16 in diode connection to bias the fifth NPN transistor Q15' results in the base voltage of Q15 at node 222 being determined by Ibias1 which is independent of Vcc variation. Consequently the emitter voltage of Q15 (also the collector voltage of Q12) at node 221 is independent of supply voltage Vcc variation. The bias circuit 250 may improve the robustness of the bias current of RF amplifier 140 over supply voltage Vcc variation. The capacitor C13 may function as a decoupling capacitor and provides an AC ground for the base of Q15. The capacitor C13 may be fixed or tunable.

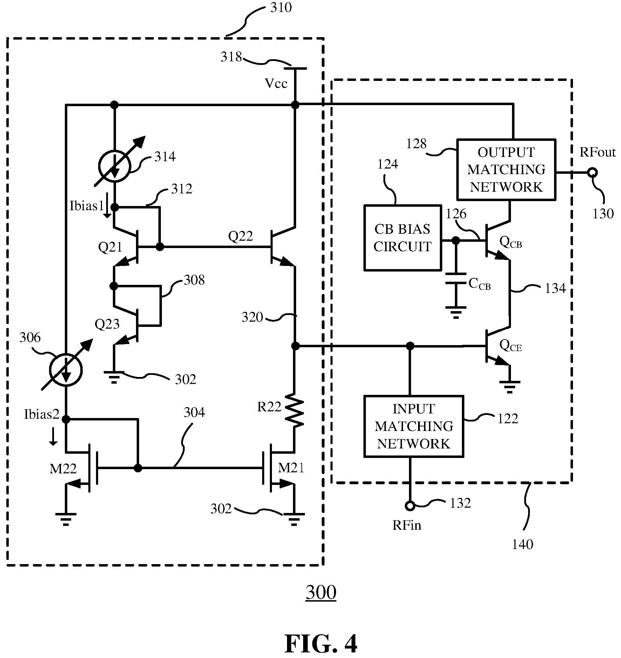

Figure 4 shows an RF amplifier 300 including a bias circuit 310 according to an embodiment. The bias circuit 310 includes a first current mirror including first NPN bipolar transistor Q21 and second NPN bipolar transistor Q22 and a second current mirror including a first MOS transistor M21 and a second MOS transistor M22. The sources of the first MOS transistor M21 and the second MOS transistor M22 are connected to ground 302. The bias circuit output 320 is connected to the first terminal of resistor R2 and to the emitter of the second NPN bipolar transistor Q22. The second terminal of resistor R2 is connected to the drain of the first MOS transistor M21. The circuit node 308 is connected to the emitter of the first NPN bipolar transistor Q21, the collector of a third NPN bipolar transistor Q23, and the base of the third NPN bipolar transistor Q23. The emitter of the third NPN bipolar transistor Q23 is connected to ground 302.

The circuit node 312 is connected to the base of the first NPN bipolar transistor Q21, the collector of the first NPN bipolar transistor Q21, the base of the second NPN bipolar transistor Q22 and a first terminal of first variable current source 314. The first NPN bipolar transistor Q21 and the third NPN bipolar transistor Q23 may be referred to as diode connected transistors. A voltage supply node 318 is connected to a second terminal of variable current source 314 and a collector of the second NPN bipolar transistor Q22.

Circuit node 304 is connected to the gates of the first and second MOS transistors M21, M22, the drain of the second MOS transistor M22 and a first terminal of the second variable current source 306. The voltage supply node 318 is connected to the second terminal of variable current source 306.

As illustrated the bias circuit 310 is connected to RF amplifier circuit 140. In other examples different RF amplifier circuits for example RF amplifier circuit 150 may be used.

In bias circuit 410, the tail current is provided by the MOS transistor M31. The first MOS transistor M31 therefore acts as a tail current source and so the emitter current of the second NPN bipolar transistor Q32 is not dominated by the base current of the common emitter transistor Q_{CE}. This may improve the robustness of the Icc bias current of the common emitter transistor Q_{CE} with respect to variations in process spread

The bias circuit 310 provides separated bias current of Ibias1 and Ibias2 using separate variable current sources 314,306. In operation, the first variable current source 314 is controlled by a controller (not shown) to apply the bias current Ibias1 to set the base voltage of transistor Q22 denoted Vb_Q22. The second variable current source 306 is controlled by a controller (not shown) to apply a second bias current Ibias2 to set the emitter current of transistor Q22, and the base-emitter voltage (Vbe) of transistor Q22, denoted Vbe_Q22 is consequentially determined by the emitter current.

The DC bias current of the RF cascode is determined by the Vbe of common emitter transistor Q_{CE}, in which Vbe _QE=Vb_Q22 - Vbe_Q22. In this way, the DC current of the bias circuit may be adapted without impacting the DC current of RF cascode transistor Q_{CE}. For example, the first bias current Ibias1 may be decreased to decrease Vb_Q22, and then the second bias current Ibias2 may be decreased which consequently decreases Vbe_Q22, while still keeping Vbe_QCE unchanged.

In contrast, for a single current bias control such as for example illustrated in the bias circuit 110 shown in Fig. 1, when bias currentIbias1 is changed, the dc current of RF cascode transistor will also be changed. The dc current of the bias circuit 110 cannot be adjusted without impacting the dc current of RF cascode. The bias circuit 310 adds extra trimming capability of amplifier modulation bandwidth. In one example by increasing the current dissipation in the common-emitter bias circuit 310, the modulation bandwidth may be improved. Alternatively, for other communication systems which do not require high modulation bandwidth, or use a Class-A amplifier which has very wide modulation bandwidth, the current dissipation of the bias circuit can be decreased and so improve the efficiency of an RF amplifier.

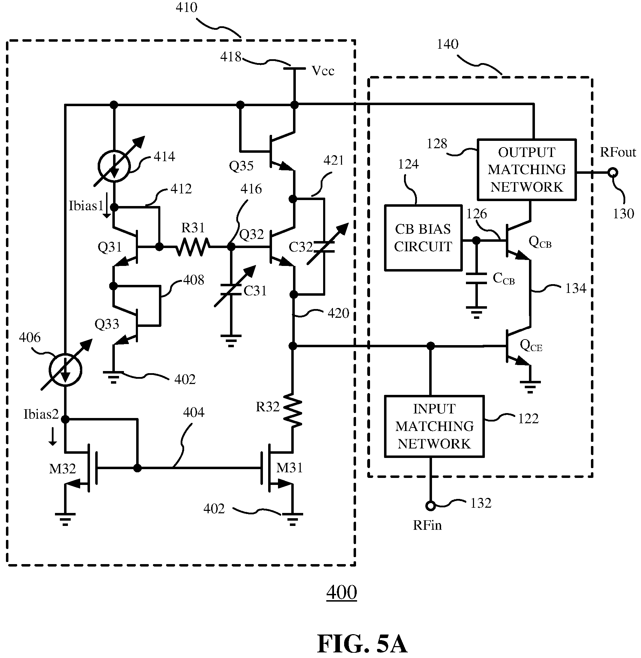

Figure 5A shows an RF amplifier 400 including a bias circuit 410 according to an embodiment. The bias circuit 410 includes a first current mirror including first NPN bipolar transistor Q31 and second NPN bipolar transistor Q32 . A second current mirror includes a first MOS transistor M31( fifth transistor) and a second MOS transistor M32 (sixth transistor). The sources of the first MOS transistor M31 and the second MOS transistor M32 are connected to ground 402. The bias circuit output 420 is connected to the first terminal of a resistor R32 and to the emitter of the second NPN bipolar transistor Q32. The second terminal of resistor R32 is connected to the drain of the first MOS transistor M31. The circuit node 408 is connected to the emitter of the first NPN bipolar transistor Q31, the collector of a third NPN bipolar transistor Q33, and the base of a third NPN bipolar transistor Q33. The emitter of the third NPN bipolar transistor Q33 is connected to ground 402.

The circuit node 412 is connected to the base of the first NPN bipolar transistor Q31, the collector of the first NPN bipolar transistor Q31, a first terminal of a first variable current source 414, and a first terminal of a first resistor R31. The first NPN bipolar transistor Q31 and the third NPN bipolar transistor Q33 may be referred to as diode connected transistors. Circuit node 416 may be connected to a second terminal of the first resistor R31, a first terminal of a first variable capacitor C31 and the base of the second NPN bipolar transistor Q32. A second terminal of the first variable capacitor C31 may be connected to ground 402. A voltage supply node 418 is connected to a second terminal of the first variable current source 414 and a collector of the second NPN bipolar transistor Q32.

A circuit node 421 is connected to a first terminal of a variable capacitor C32, the emitter of a fourth NPN bipolar transistor Q35 and the collector of the second NPN bipolar transistor Q32. A second terminal of the variable capacitor C32 is connected to the bias circuit output 420. The voltage supply node 418 is connected to the collector and base of the second NPN bipolar transistor Q32.

A circuit node 404 is connected to the gates of the first and second MOS transistors M31, M32, the drain of the second MOS transistor M32 and a first terminal of the second variable current source 406. The voltage supply node 418 is connected to the second terminal of variable current source 406.

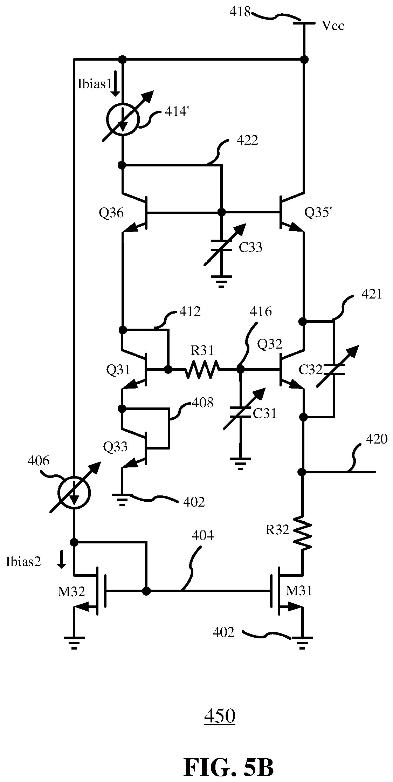

Figure 5B shows a bias circuit 450 for an RF amplifier which is similar to bias circuit 410. In the bias circuit 450, the fourth transistor Q35' has a base connected to circuit node 422, a collector connected to the supply node 418 and an emitter connected to circuit node 421. The first current bias 414' is connected between the supply node 418 and circuit node 422. A fifth bipolar NPN transistor Q36 (seventh transistor) has a base and collector connected to circuit node 422. A capacitor C33 which may be a variable capacitor may have a first terminal connected to circuit node 422 and a second terminal connected to ground 402. In other respects the circuit is the same as bias circuit 410.

The addition of the fifth bipolar transistor Q36 in diode connection to bias the fourth NPN transistor Q35' results in the base voltage of Q35 at node 222 being determined by Ibias1 which is independent to Vcc variation, similarly as described for bias circuit 250 Consequently the emitter voltage of Q35 (also the collector voltage of Q32) at node 421 is independent of Vcc variation. Similarly to bias circuit 250, bias circuit 450 improves the robustness of the bias current of RF amplifier 140 over Vcc variation. Capacitor C33 serves as decoupling capacitor and provides an AC ground for the base of Q35'. Capacitor C33 may be fixed or tunable.

Bias circuits 410, 450 include the following features which may improve the performance and/or trimming capability. Firstly an extra tuneable capacitor for example capacitor C32 coupled to the collector and emitter of a self-bias boosting transistor for example NPN transistor Q32, which may improve a modulation bandwidth of the amplifier. Secondly, separate control of the dc bias of base voltage with current source 414, 414' and emitter current with current source 406 of self-bias boosting transistor Q32 may allow variable current dissipation of bias circuit and improve trimming capability. For example the bias current may be trimmed for a wider modulation bandwidth, without impacting the AMAM and AMPM of the amplifier. Alternatively the current dissipation of bias circuit may be significantly decreased for modulation bandwidth non-critical applications or for Class-A amplifier topologies. Thirdly, configuring a capacitor C31 at the base of the self-bias boosting transistor Q32 in a tuneable way may allow trimming of the AMAM characteristic without impacting the quiescent current and AMPM characteristic of the RF amplifier.

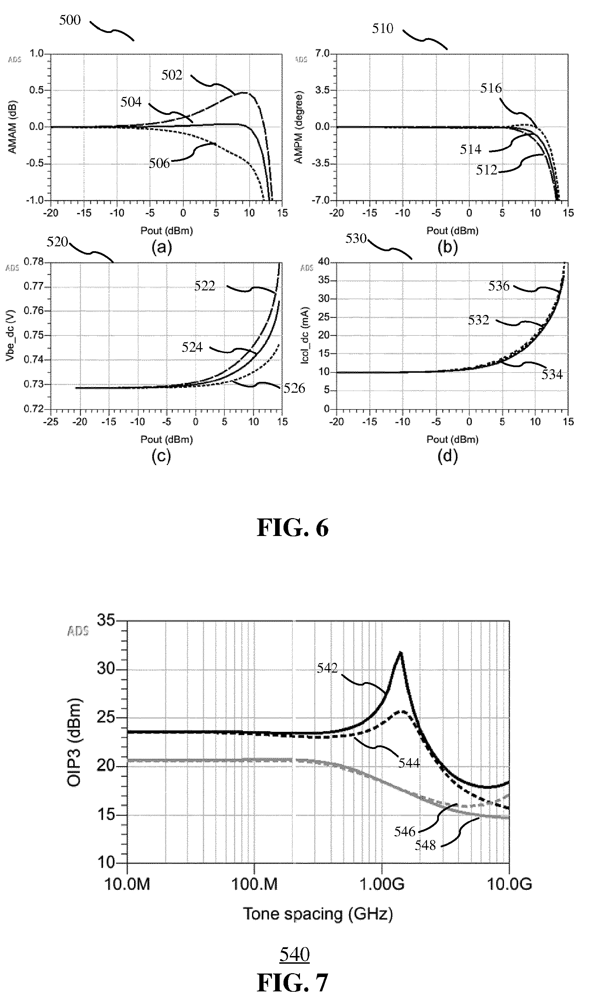

Figure 6 shows graphs 500, 510, 520, 530 illustrating the effect of varying the capacitor C31 in RF amplifier 400 which corresponds to the variable capacitor C1 in RF amplifier 100. The x-axis in each of the graphs 500, 510, 520, 530 shows output power (Pout) in dBm varying between -20 and +15. Lines 502,512,522,532 show the variation for a capacitor value of 16 fF. Lines 504,514,524,534 show the variation for a capacitor value of 10 fF. Lines 506,516,526,536 show the variation for a capacitor value of 6 fF. Graph 500 shows AMAM distortion in dB ranging from -1 to + 1 dB on the y-axis. Graph 510 shows the variation of AMPM distortion in degrees between -7 and +7 on the y-axis.

Graph 520 shows the dc component of base-to-emitter voltage (Vbe_dc) of the collector-emitter (CE) stage of second bipolar transistor Q32 versus output power Pout. The transistor Q32 corresponds to transistor Q2 in bias circuit 110. Graph 520 indicates the operational principle of AMAM control. When RF input power increases, RF voltage swing at base-to-emitter junction of Q32 is correspondingly increased. Since the dc component of Q32 emitter current (IE_dc) is fixed, Q32 base-to-emitter junction is rectified and Vbe_dc of Q32 is decreased. The Q32 Vbe_dc is adaptively increased with Pout.

Since resistance R31 ( R1) is typically relatively large for example approximately 1 KOhm or more and blocks the RF signal, capacitor C31 (C1) works as the capacitive feedback for Q32 (Q2). If the capacitance of C1 increases, the RF swing across Q32 base-to-emitter junction will increase, and Q32 is more strongly rectified and results in more Q32 Vbe_dc decrease. Hence, the Q32 Vbe_dc increase with Pout is higher with a larger value of capacitor C31, as shown in graph 520 and for the AMAM distortion in graph 500 gets more expansion with larger values of capacitor C31.

Graph 530 shows the dc component of collector current of CE stage Q2 varying between 0 and 40 mA. Graph 530 illustrates that the AMAM control is independent of quiescent current. For a linear amplifier design, it may be desirable to achieve a flat AMAM and AMPM response over Pout, and thus solid lines (C31= 10 fF) is the default value. If the AMAM characteristic is not flat during test, the C31 value may be trimmed to make the AMAM more flat. The variable capacitor C31 may be implemented for example using a varactor or a switchable capacitor network.

Figure 7 illustrates how the combination of variable capacitors C32 and transistor Q35 may improve the modulation bandwidth of amplifier 400. Figure 7 illustrates a graph 540 of the amplifier 400 OIP3 (dBm) on the y-axis ranging from 10 to 35 dBm versus tone spacing on a logarithmic scale on the x-axis varying between 10 MHz and 10 GHz for a two-tone signal.

Solid lines 542, 548 and dotted lines 544, 546 refer to low (2*f1-f2) and high (2*f2-f1) side OIP3, respectively. Lines 542, 544 refer to a value C32 of 120 ff, lines 546, 548 refer to C32 value of 0 fF. In one non-limiting example, An 3^{rd} order output intercept point (OIP3) above 20-dBm may be achieved for a 100-GHz power amplifier (PA). The addition of capacitor C32 may significantly improve the modulation bandwidth from below 1-GHz to around 3-GHz.

The transistor Q35 in diode connection is provides isolation from the supply voltage Vcc. If Q35 is omitted, C32 is then directly coupled to Vcc, which is effectively RF ground, and so C32 will not affect the modulation bandwidth.

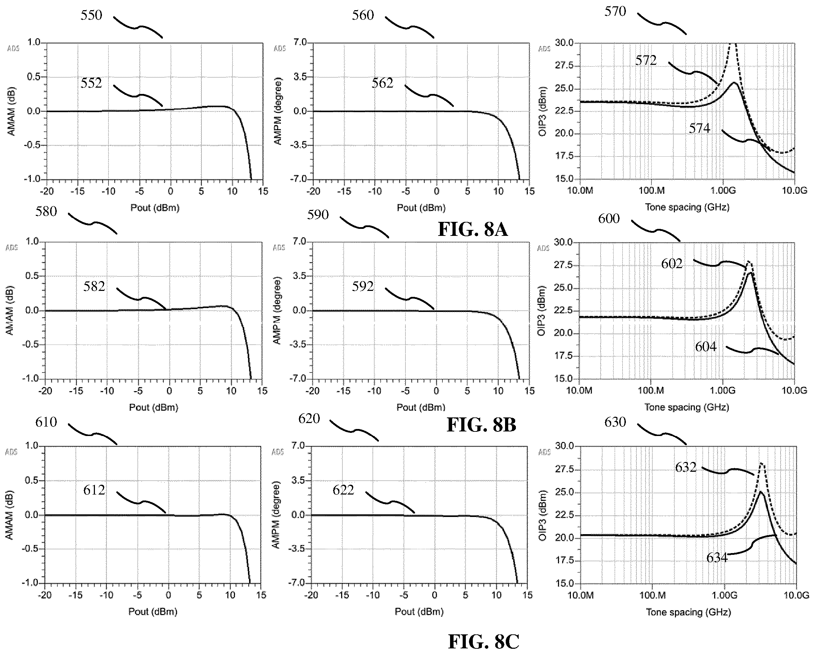

Figures 8A, 8B, 8C shows the three different combinations of Ibias1 and Ibias2, which presents very similar AMAM and AMPM behavior but different modulation bandwidth. The x-axis in each of the graphs 550, 560, 580, 590, 610, 620 shows output power (Pout) in dBm varying between -20 and +15. Graphs 550, 580,610 shows AMAM distortion 552, 582, 612 in dB ranging from -1 to + 1 dB on the y-axis. Graphs 560, 590, 620 show the variation of AMPM distortion 562, 592, 622 in degrees between -7 and +7 on the y-axis.

Graphs 570, 600, 630 shows the OIP3 for a two -tone signal with a y-axis in dBm ranging from 10 to 35 dBm versus tone spacing on a logarithmic scale on the x-axis varying between 10 MHz and 10 GHz for a two-tone signal. Solid lines 574, 604, 634 and dotted lines 572, 602, 632 refer to low (2*f1-f2) and high (2*f2-f1) side OIP3, respectively.

In Figures 8A, 8B, 8C, the tone spacing frequencies with OIP3 > 20 dBm are 3,4, and 5 GHz, respectively. The bias current settings are 370 uA, 490 uA and 580 uA respectively for the first bias current Ibias1 and 150 uA, 300 uA and 450 uA respectively for the second bias current Ibias2. Hence, by increasing the current dissipation in the CE bias, the modulation bandwidth may be improved.

If the second bias current value Ibias2 is increased, Q32 I_{E}_dc and Vbe_dc are increased. Subsequently Ibias1 may be increased to increase Q32 Vb_dc and keep Q32 Ve_dc constant. Thus, Vbe_dc for transistor Q32 and the quiescent bias current may remain constant by increasing Ibias1 and Ibias2 at the same time. The RF signal swing across the base-to-emitter junction of Q32 and the rectification operation of Q32 is dominantly determined by capacitor C31. Hence, with different combinations of Ibias1 and Ibias2, the CE- stage Q_{CE} may be provided with the same quiescent current bias and the same adaptive Vbe_dc increase over Pout. Consequently graphs 550, 580, 610 show the same AMAM response over Pout and graphs 560, 590, 622 show the same AMPM response over Pout.

One of the root causes of the memory effect is that ce bias cannot trace the fast envelop of the modulation signal which causes the ce stage Vbe_dc increase over Pout under fast modulation signal behaves differently from under CW case. With the increased Ibias2 and Q32 I_{E}_dc, the fmax and ft of Q32 is increased. Thus, the rectification of Q32 and ce bias circuit can handle a faster signal envelope increasing the modulation (OIP3) bandwidth from the situation illustrated in Figure 8A to the situation of Figure 8C.

The detailed circuit embodiment of tunable Ibias1 and Ibias2 could be switchable current mirrors or IDAC (Digital-to-Analog Convertors with current output).

Embodiments of the bias circuit and RF amplifier circuits described have been illustrated with NPN transistors and NMOS transistors. However it will be appreciated that similar circuit configurations using solely MOS transistors (nMOS or PMOS) and bipolar transistors (NPN or PNP) may be used. In some examples, a bipolar transistor having a first transistor terminal ( collector or emitter ), second transistor terminal ( emitter or collector ) and transistor control terminal (base) may be replaced by an MOS transistor having a first transistor terminal (drain or source ), second transistor terminal (source or drain) and transistor control terminal (gate) and vice-versa.

Embodiments describe a common-emitter (CE) bias circuit for the RF amplifier. Embodiments may include one or more of the following features which may improve the performance and/or trimming capability for the bias circuit:

An extra tuneable capacitor for example capacitors C12 and C32 coupled to the collector and emitter of a self-bias boosting NPN transistor for example transistors Q12 and Q32, which may improve a modulation bandwidth of amplifier.

Separate control of the dc bias of base voltage and emitter current of self-bias boosting NPN which may allow variable current dissipation of bias circuit and improve trimming capability. For example the bias current can be trimmed for a wider modulation bandwidth, without impacting the AMAM and AMPM of the amplifier. Alternatively the current dissipation of bias circuit may be significantly decreased for modulation bandwidth non-critical applications or for Class-A amplifier topologies.

Configuring a capacitor, for example capacitor C1, C31 at the base of a self-bias boosting NPN in a tuneable way, which can trim the AMAM without impacting the quiescent current and AMPM of the RF amplifier.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A bias circuit (410, 450) for a RF amplifier (400), the bias circuit further comprising:
a first transistor (Q31) and a second transistor (Q32) configured as a first current mirror, wherein the first transistor and the second transistor are bipolar transistors;
a first current source (414, 414') arranged between a supply node (418) and a collector of the first transistor, the collector of the first transistor being coupled to the base of the first transistor ;
a bias circuit output (420) coupled to an emitter of the second transistor;
a second current mirror (M31, M32) coupled to the first current mirror (Q31, Q32) and the bias circuit output (420); and a second current source (406) arranged between the supply node and the second current mirror (M31, M32); and a third transistor (Q33) in a diode-connected configuration coupled between an emitter of the first transistor and a ground wherein the second current source is a variable current source;
a first variable capacitor (C32) coupled between a collector of the second transistor and the emitter of the second transistor; and
a fourth transistor (Q35, Q35') having a fourth transistor control terminal, a fourth transistor first terminal coupled to the supply node (418) and a fourth transistor second terminal coupled to the collector of the second transistor;
wherein the second current mirror further comprises a fifth transistor (M31) and a sixth transistor (M32); the fifth transistor (M31) comprises a fifth transistor first terminal coupled to the bias circuit output (420), a fifth transistor second terminal coupled to the ground (402), and a fifth transistor control terminal; and the sixth transistor (M32) comprises a sixth transistor first terminal coupled to the supply node (418) via the second current source (406) and the fifth transistor control terminal, a sixth transistor second terminal coupled to the ground (402), and a sixth transistor control terminal coupled to the fifth transistor control termina and to the sixth transistor first terminal

2. The bias circuit (410, 450) of claim 1 further comprising:
a first resistor (R31) coupled between the base of the first transistor and the base of the second transistor and a second variable capacitor (C31) coupled between the base of the second transistor and the ground (402).

3. The bias circuit (410, 450) of claim 2, wherein the second variable capacitor (C31) comprises one of a varactor and switchable capacitor network.

4. The bias circuit (410, 450) of any preceding claim , wherein the fourth transistor (Q35, Q35') is a bipolar transistor.

5. The bias circuit (410, 450) of any preceding claim, wherein the second current mirror further comprises a second resistor (R32) coupled between the fifth transistor first terminal and the bias circuit output (420).

6. The bias circuit (410, 450) of any preceding claim, wherein fifth and sixth transistors (M31, M32) are MOS transistors.

7. The bias circuit (450) of any preceding claim, further comprising :
a seventh transistor (Q36) having a seventh transistor control terminal coupled to the fourth transistor control terminal, a seventh transistor first terminal coupled to the first current source (414') and a seventh transistor second terminal coupled to the collector of the first transistor wherein the seventh transistor (Q36) is diode connected;
and a third capacitor (C33) having a first terminal coupled to the fourth transistor control terminal and a second terminal coupled to ground (402).

8. An RF amplifier (400) comprising the bias circuit (410, 450) of any preceding claim coupled to an RF amplifier circuit (140,150).

## Patentansprüche

1. Vorspannungsschaltung (410, 450) für einen HF-Verstärker (400), wobei die Vorspannungsschaltung ferner Folgendes umfasst:
einen ersten Transistor (Q31) und einen zweiten Transistor (Q32), die als ein erster Stromspiegel konfiguriert sind, wobei der erste Transistor und der zweite Transistor Bipolartransistoren sind;
eine erste Stromquelle (414, 414'), die zwischen einem Versorgungsknoten (418) und einem Kollektor des ersten Transistors angeordnet ist, wobei der Kollektor des ersten Transistors mit der Basis des ersten Transistors gekoppelt ist;
einen Vorspannungsschaltungsausgang (420), der mit einem Emitter des zweiten Transistors gekoppelt ist;
einen zweiten Stromspiegel (M31, M32), der mit dem ersten Stromspiegel (Q31, Q32) und dem Vorspannungsschaltungsausgang (420) gekoppelt ist; und
eine zweite Stromquelle (406), die zwischen dem Versorgungsknoten und dem zweiten Stromspiegel (M31, M32) angeordnet ist; und einen dritten Transistor (Q33) in einer diodenverbundenen Konfiguration, der zwischen einem Emitter des ersten Transistors und einer Masse gekoppelt ist, wobei die zweite Stromquelle eine variable Stromquelle ist;
einen ersten variablen Kondensator (C32), der zwischen einem Kollektor des zweiten Transistors und dem Emitter des zweiten Transistors gekoppelt ist; und
einen vierten Transistor (Q35, Q35') mit einem vierten Transistorsteueranschluss, einem ersten Anschluss des vierten Transistors, der mit dem Versorgungsknoten (418) gekoppelt ist, und einem zweiten Anschluss des vierten Transistors, der mit dem Kollektor des zweiten Transistors gekoppelt ist;
wobei der zweite Stromspiegel ferner einen fünften Transistor (M31) und einen sechsten Transistor (M32) umfasst; der fünfte Transistor (M31) einen ersten Anschluss des fünften Transistors, der mit dem Vorspannungsschaltungsausgang (420) gekoppelt ist, einen zweiten Anschluss des fünften Transistors, der mit der Masse (402) gekoppelt ist, und einen Steueranschluss des fünften Transistors umfasst; und der sechste Transistor (M32) einen ersten Anschluss des sechsten Transistors, der über die zweite Stromquelle (406) und den fünften Transistorsteueranschluss mit dem Versorgungsknoten (418) gekoppelt ist, einen zweiten Anschluss des sechsten Transistors, der mit der Masse (402) gekoppelt ist, und einen sechsten Transistorsteueranschluss, der mit dem fünften Transistorsteueranschluss und dem ersten Anschluss des sechsten Transistors gekoppelt ist, umfasst.

2. Vorspannungsschaltung (410, 450) nach Anspruch 1, die ferner Folgendes umfasst:
einen ersten Widerstand (R31), der zwischen der Basis des ersten Transistors und der Basis des zweiten Transistors gekoppelt ist, und einen zweiten variablen Kondensator (C31), der zwischen der Basis des zweiten Transistors und der Masse (402)gekoppelt ist.

3. Vorspannungsschaltung (410, 450) nach Anspruch 2, wobei der zweite variable Kondensator (C31) eines aus einem Varaktor und einem schaltbaren Kondensatornetzwerk umfasst.

4. Vorspannungsschaltung (410, 450) nach einem der vorhergehenden Ansprüche, wobei der vierte Transistor (Q35, Q35') ein Bipolartransistor ist.

5. Vorspannungsschaltung (410, 450) nach einem der vorhergehenden Ansprüche, wobei der zweite Stromspiegel ferner einen zweiten Widerstand (R32) umfasst, der zwischen dem ersten Anschluss des fünften Transistors und dem Vorspannungsschaltungsausgang (420) gekoppelt ist.

6. Vorspannungsschaltung (410, 450) nach einem der vorhergehenden Ansprüche, wobei fünfte und sechste Transistoren (M31, M32) MOS-Transistoren sind.

7. Vorspannungsschaltung (450) nach einem der vorhergehenden Ansprüche, die ferner Folgendes umfasst:
einen siebten Transistor (Q36) mit einem siebten Transistorsteueranschluss, der mit dem vierten Transistorsteueranschluss gekoppelt ist, einen ersten Anschluss des siebten Transistors, der mit der ersten Stromquelle (414') gekoppelt ist, und einen zweiten Anschluss des siebten Transistors, der mit dem Kollektor des ersten Transistors gekoppelt ist, wobei der siebte Transistor (Q36) diodenverbunden ist;
und einen dritten Kondensator (C33) mit einem ersten Anschluss, der mit dem vierten Transistorsteueranschluss gekoppelt ist, und einem zweiten Anschluss, der mit Masse (402) gekoppelt ist.

8. HF-Verstärker (400), umfassend die Vorspannungsschaltung (410, 450) nach einem der vorhergehenden Ansprüche, gekoppelt mit einer HF-Verstärkerschaltung (140, 150).

## Revendications

1. Circuit de polarisation (410, 450) pour un amplificateur RF (400), le circuit de polarisation comprenant en outre :
un premier transistor (Q31) et un deuxième transistor (Q32) configurés sous forme de premier miroir de courant, dans lequel le premier transistor et le deuxième transistor sont des transistors bipolaires ;
une première source de courant (414, 414') agencée entre un nœud d'alimentation (418) et un collecteur du premier transistor, le collecteur du premier transistor étant couplé à la base du premier transistor ;
une sortie de circuit de polarisation (420) couplée à un émetteur du deuxième transistor ;
un second miroir de courant (M31, M32) couplé au premier miroir de courant (Q31, Q32) et à la sortie de circuit de polarisation (420) ; et une seconde source de courant (406) agencée entre le nœud d'alimentation et le second miroir de courant (M31, M32) ; et un troisième transistor (Q33) dans une configuration connectée par diode, couplé entre un émetteur du premier transistor et une masse, dans lequel la seconde source de courant est une source de courant variable ;
un premier condensateur variable (C32) couplé entre un collecteur du deuxième transistor et l'émetteur du deuxième transistor ; et
un quatrième transistor (Q35, Q35') ayant une borne de commande de quatrième transistor, une première borne de quatrième transistor couplée au nœud d'alimentation (418) et une seconde borne de quatrième transistor couplée au collecteur du deuxième transistor ;
dans lequel le second miroir de courant comprend en outre un cinquième transistor (M31) et un sixième transistor (M32) ; le cinquième transistor (M31) comprend une première borne de cinquième transistor couplée à la sortie de circuit de polarisation (420), une seconde borne de cinquième transistor couplée à la masse (402), et une borne de commande de cinquième transistor ; et le sixième transistor (M32) comprend une première borne de sixième transistor couplée au nœud d'alimentation (418) par l'intermédiaire de la seconde source de courant (406) et de la borne de commande de cinquième transistor, une seconde borne de sixième transistor couplée à la masse (402), et une borne de commande de sixième transistor couplée à la borne de commande de cinquième transistor et à la première borne de sixième transistor.

2. Circuit de polarisation (410, 450) de la revendication 1, comprenant en outre :
une première résistance (R31) couplée entre la base du premier transistor et la base du deuxième transistor et un second condensateur variable (C31) couplé entre la base du deuxième transistor et la masse (402).

3. Circuit de polarisation (410, 450) de la revendication 2, dans lequel le second condensateur variable (C31) comprend un d'une diode varactor et d'un réseau condensateur commutable.

4. Circuit de polarisation (410, 450) d'une quelconque revendication précédente, dans lequel le quatrième transistor (Q35, Q35') est un transistor bipolaire.

5. Circuit de polarisation (410, 450) d'une quelconque revendication précédente, dans lequel le second miroir de courant comprend en outre une seconde résistance (R32) couplée entre la première borne de cinquième transistor et la sortie de circuit de polarisation (420).

6. Circuit de polarisation (410, 450) d'une quelconque revendication précédente, dans lequel les cinquième et sixième transistors (M31, M32) sont des transistors MOS.

7. Circuit de polarisation (450) d'une quelconque revendication précédente, comprenant en outre :
un septième transistor (Q36) ayant une borne de commande de septième transistor couplée à la borne de commande de quatrième transistor, une première borne de septième transistor couplée à la première source de courant (414') et une seconde borne de septième transistor couplée au collecteur du premier transistor, dans lequel le septième transistor (Q36) est connecté par diode ;
et un troisième condensateur (C33) ayant une première borne couplée à la borne de commande de quatrième transistor et une seconde borne couplée à la masse (402).

8. Amplificateur RF (400), comprenant le circuit de polarisation (410, 450) d'une quelconque revendication précédente, couplé à un circuit d'amplificateur RF (140, 150).
